# EUROPEAN PATENT SPECIFICATION

(11) **EP 1 955 464 B1**
(45) Date of publication and mention of the grant of the patent: **30.10.2013**
(21) Application number: 06820360.3
(22) Date of filing: 28.11.2006
(51) Int. Cl.: H04J 14/08, H03M 1/12

(54) **A METHOD AND DEVICE FOR DIGITISING AN ELECTRICAL SIGNAL**
VERFAHREN UND EINRICHTUNG ZUM DIGITALISIEREN EINES ELEKTRISCHEN SIGNALS
PROCEDE ET DISPOSITIF DE NUMERISATION D'UN SIGNAL ELECTRIQUE

(30) Priority: 01.12.2005 GB 0524461
(43) Date of publication of application: 13.08.2008
(73) Proprietor: U2T Photonics UK Limited, London EC4A 3TW (GB)
(72) Inventor: HEATON, John, DL5 6JW (GB)
(74) Representative: McDonough, Jonathan
(86) International application number: PCT/GB2006/004450
(87) International publication number: WO 2007/063292

(56) References cited:
- US-A- 5 010 346
- US-A- 6 100 831
- KANG J U ET AL: "Demonstration of time interweaved photonic four-channel WDM sampler for hybrid analogue-digital converter" ELECTRONICS LETTERS, IEE STEVENAGE, GB, vol. 35, no. 1, 7 January 1999 (1999-01-07), pages 60-61, XP006011633 ISSN: 0013-5194
- YARIV A ET AL: "Time interleaved optical sampling for ultra-high speed A/D conversion" ELECTRONICS LETTERS, IEE STEVENAGE, GB, vol. 34, no. 21, 15 October 1998 (1998-10-15), pages 2012-2013, XP006010463 ISSN: 0013-5194

## Description

The present invention relates to a method and device for digitising an electrical signal, preferably a microwave signal. More particularly, but not exclusively, the present invention relates to a method of digitising a microwave signal comprising the steps of providing a plurality of laser pulse trains of different wavelengths, introducing a time delay between each of the pulse trains, passing each of the pulse trains through a modulator where they are modulated by an optical microwave signal, splitting the modulated signals into a plurality of wavelength dependent paths and digitising the received signal in each path. The present invention also relates to a device for performing such a method.

Devices for digitising microwave signals are known. Such devices use either time division multiplexing (TDM) or wavelength division multiplexing (WDM). TDM systems provide a succession of optical pulses. These are modulated by the microwave signal. A high speed RF driven optical switching element sends successive pulses along different optical paths. An analogue to digital converter in each path digitises the received pulses. The high speed optical element is difficult and expensive to manufacture and is also difficult to drive electrically.

WDM systems provide a series of pulses of different wavelengths. These are modulated by the microwave signal before being split into different optical paths by an arrayed waveguide grating before being digitised. It is difficult to generate a series of pulses with different wavelengths from one pulse to the next. Such WDM systems are complex and difficult to manufacture.

US 5010346 discloses an electro-optical analogue to digital converter comprising a plurality of mode-locked lasers driven by a clock. The signal from the clock drives the lasers to fire. The pulses then travel down different paths to an optical combiner where they arrive one at a time, are modulated, split and then provided to the photo detectors.

Document "Optical sampling of narrowband microwave signals using pulses generated by electroabsorption modulators", Avi Zeitouny, Zeev Tamir, Alfred Feldster, Moshe Horowitz; Optics Communications 256 (2005) 248-255, discloses an optical system for sampling narrowband microwave signals with a very high carrier frequency, based on optical pulses generated by two electroabsorption modulators.

Accordingly, a first aspect of the invention provides a device for digitising an electrical signal according to claim 1.

Using this approach to make a photonic analogue to digital converter (ADC) enables sampling and digitisation of arbitrary electronic, preferably microwave signals to be achieved at significantly higher sampling rates and microwave signal bandwidths than can be achieved with purely electronic ADCs.

The use of continuous wave lasers allows the device to sample signals with higher precision than other wavelength division multiplexed architectures. Other WDM systems require a short pulsed (mode locked) laser which may not have a stable enough pulse to pulse power jitter to give a high enough effective number of bits (ENOB) or spurious free dynamic range (SFDR).

In addition the device according to the invention allows a complex sampling function to be achieved using simple passive photonic components. The device according to the invention is reliable and lightweight and is particularly suitable for use in high performance avionic and naval electronic warfare applications. Other applications include high speed single shot oscilloscopes and spectrum analysers.

Preferably the dispersive optical chopper comprises an optical combiner having a plurality of input ports each adapted to receive the output of a laser and an output port, the optical combiner being adapted to combine the optical signals received at the plurality of input ports at the output port.

Preferably, the dispersive optical chopper comprises at least one optical pulse generator adapted to receive continuous optical signals at one or more wavelengths and to convert these to one or more optical pulse trains at these wavelengths.

The pulse generator can be adapted to receive the output of the optical combiner.

The device can further comprise a dispersive optical element connected between the pulse generator and the port of the optical modulator to introduce a wavelength dependent delay between optical pulse trains received from the optical pulse generator.

The device can comprise a plurality of optical pulse generators, one being connected between each of the lasers and a corresponding input port of the optical combiner.

The device can comprise a dispersive optical element connected between the output of the optical combiner and the modulator.

Alternatively, the device can comprise a plurality of delay elements, one being connected between each optical pulse generator and the corresponding input of the optical combiner, each delay element being adapted to introduce a predetermined delay in the optical signal passing through the delay element.

The dispersive optical element can comprise an optical fibre, preferably a fibre optic cable.

The dispersive optical element can be a fibre bragg grating.

The dispersive optical element can be an echelle grating.

The dispersive optical element can comprise
(i) a second optical splitter adapted to split received optical pulse trains into a plurality of wavelength dependent paths;
(ii) a second optical combiner adapted to receive optical signals at a plurality of input ports and combine them at an output port, and
(iii) a plurality of delay elements, each delay element being connected between an output of the second optical splitter and a corresponding input of the second optical combiner.

The delay element can comprise an optical fibre, preferably a fibre optic cable.

The at least one optical splitter can be an arrayed waveguide grating.

The at least one optical splitter can be a thin film filter.

The at least one optical splitter can be a planar waveguide echelle grating.

The at least one optical combiner can be an arrayed waveguide grating.

The at least one optical combiner can be a thin film filter.

The at least one optical combiner can be a planar waveguide echelle grating.

In a further aspect of the invention there is provided a method of digitising an electrical signal according to claim 13.

The output of the plurality of lasers can be combined into a single path before modulation.

The combination can be performed by an arrayed waveguide grating.

Alternatively, the combination can be performed by a thin film filter.

The combination can be performed by an echelle grating.

Preferably, each of the outputs is converted to an optical pulse train before combination.

The predetermined time delay can be introduced between the optical pulse trains before combination.

The time delay can be introduced by passing the optical pulse trains through at least one dispersive optical element, preferably an optical fibre, more preferably a fibre optic cable The dispersive optical element can be an echelle grating or fibre Bragg grating.

Each of the outputs of the plurality of lasers can be converted to a optical pulse train after combination.

A predetermined delay can be introduced between the optical pulse trains after combination.

The present invention will now be described by way of example only and not in any limitative sense with reference to the accompanying drawings in which
figure 1 shows a first embodiment of a device according to the invention;
figure 2 shows a second embodiment of a device according to the invention;
figure 3 shows a third embodiment of a device according to the invention;
figure 4 shows a fourth embodiment of a device according to the invention;
figure 5 shows a fifth embodiment of a device according to the invention;
figure 6 shows a sixth embodiment of a device according to the invention;
figure 7 shows a thin film filter multiplexer/demultiplexer; and
figure 8 shows a planar waveguide echelle grating multiplexer/demultiplexer:

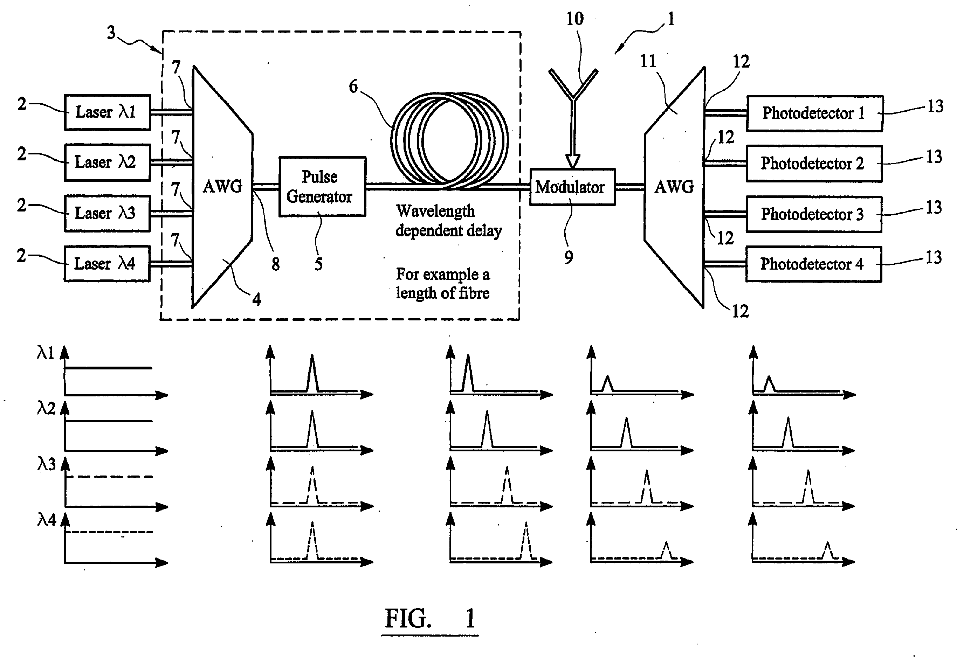

Shown in figure 1 is a device for digitising a microwave signal according to the invention. The device 1 comprises a plurality of continuous wave (CW) lasers 2 each having a different wavelength from the others. The output from each of the continuous wave lasers 2 is received by a dispersive optical chopper 3. The dispersive optical chopper 3 comprises an arrayed waveguide grating (AWG) 4, a pulse generator 5 and a dispersive optical element 6, the function of each of which is described below. The AWG 4 comprises a plurality of input ports 7, each of which is adapted to receive the output of a corresponding CW laser 2. The AWG 4 combines the signal received at the plurality of input ports 7 at a single output port 8.

Connected to the output port 8 of the AWG 4 is the pulse generator 5. The pulse generator 5 receives the continuous wave output of the AWG 4 at a plurality of wavelengths and converts these into optical pulse trains at the same wavelengths. The optical pulse trains may be several wavelengths long. Typically the pulse is less than 1ns but longer than 1fs. The pulse generator of the embodiment is a stable low jitter electro-refractive pulse generator.

Extending from the output of the pulse generator 5 is the dispersive optical element 6 comprising fibre optic cable 6. A dispersive fibre optic cable 6 is one where the speed of light through the cable varies with the wavelength of the light. The dispersive fibre optic cable 6 introduces a very accurately known timing separation between the different wavelength optical pulse trains as they exit the fibre optic cable 6.

The dispersed optical pulse trains are received by a modulator 9. As the optical pulse trains pass through the modulator 9 they are modulated by a received analogue microwave signal 10. The amplitude of the signal output from the modulator 9 depends upon the amplitude of the microwave signal. The operation of such modulators 9 is well known and will not be described further.

The output from the modulator 9 is received by an optical splitter 11 comprising an AWG 11. The AWG 11 splits the modulator output into a plurality of wavelength dependent optical paths 12. Each of the optical paths 12 receives the optical pulse train from one of the CW lasers 2.

A plurality of photodetectors 13 are connected one to each of the outputs 12 of the AWG splitter 11. Filters (not shown) are connected to the outputs of the photodetectors 13 to broaden the received optical pulses which are in turn read by electronic analogue to digital converters (ADCs) (not shown).

The device according to the invention has the advantage that the microwave signal can be sampled at very short time intervals - the time between the different wavelength optical pulse trains as they leave the optical fibre 6. The analogue to digital converter however need only digitise the received signals at the rate the pulse generator 5 generates optical pulse trains

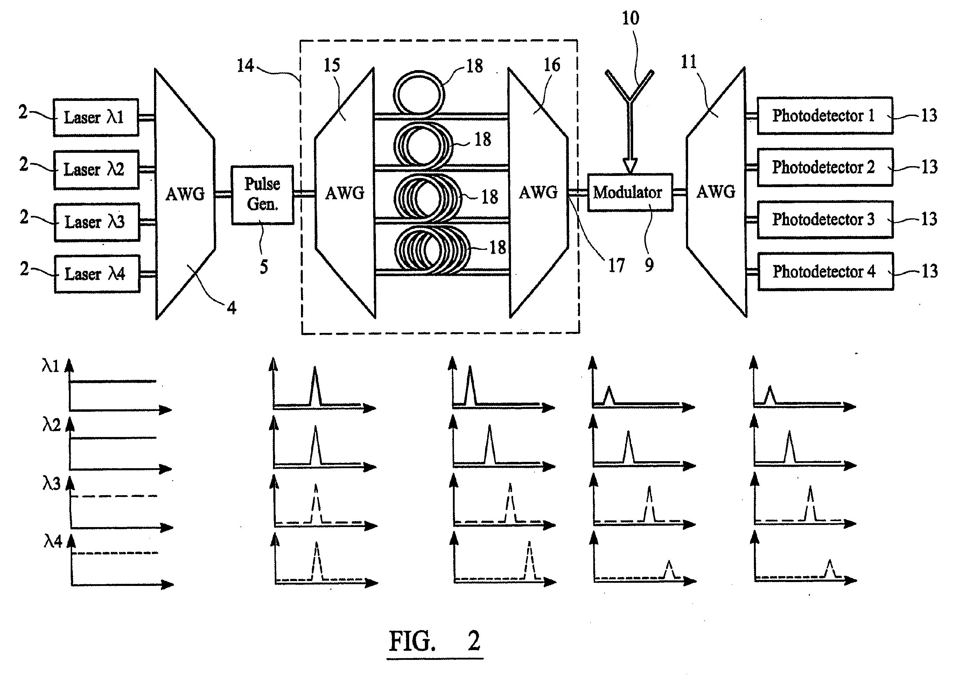

Shown in figure 2 is a second embodiment of a device according to the invention. The device of figure 2 is similar to that of figure 1 except the dispersive fibre optic cable 6 is replaced by a more complex dispersive optical element 14. The dispersive optical element 14 of figure 2 comprises a second AWG splitter 15 which splits the optical pulse trains received from the pulse generator 5 into a plurality of wavelength dependent paths. The dispersive optical element also comprises an AWG optical combiner 16 which combines the optical pulse trains at a plurality of input ports at a single output port 17. The output port 17 is connected to the input of the modulator 9. Extending between each of the outputs of the second optical splitter 15 and a corresponding input of the AWG combiner 16 is a delay element 18 which in this embodiment comprises an optical fibre 18. Each of the optical fibres 18 introduces a different delay to the optical pulse train passing along it. Hence, when the optical pulse trains are combined there is a controlled time delay between each of them.

The embodiment of figure 2 has the advantage that each optical pulse train passes along a different dispersive optical fibre 18 according to its wavelength. One therefore has a greater degree of control over the time delay between the optical pulse trains as they are received by the modulator 9. By altering the length of one of these fibres 18 one can alter the delay of an optical pulse train of one particular wavelength without affecting the delay of the other optical pulse trains.

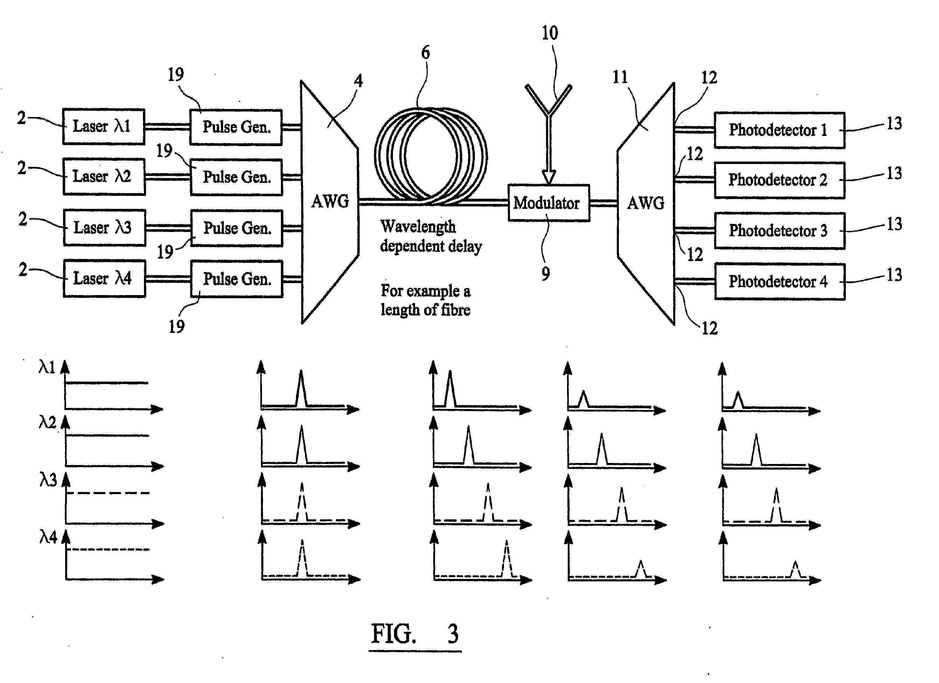

Shown in figure 3 is a third embodiment of a device according to the invention. This embodiment is similar to that of figure 1 except the single pulse generator 5 is replaced by a plurality of pulse generators 19, each one connected between a CW laser 2 and a corresponding input port of the AWG optical combiner 4. The method of operation of this device is similar to the device of figure 1 except each pulse generator 5 produces an optical pulse train before the AWG optical combiner 4. The combiner 4 then combines these optical pulse trains before they are passed to the dispersive fibre optic cable 6.

This embodiment has the advantage that different pulse generators 19 can be driven at different clock rates for recovering the original frequency in under-sampled analogue microwave signals.

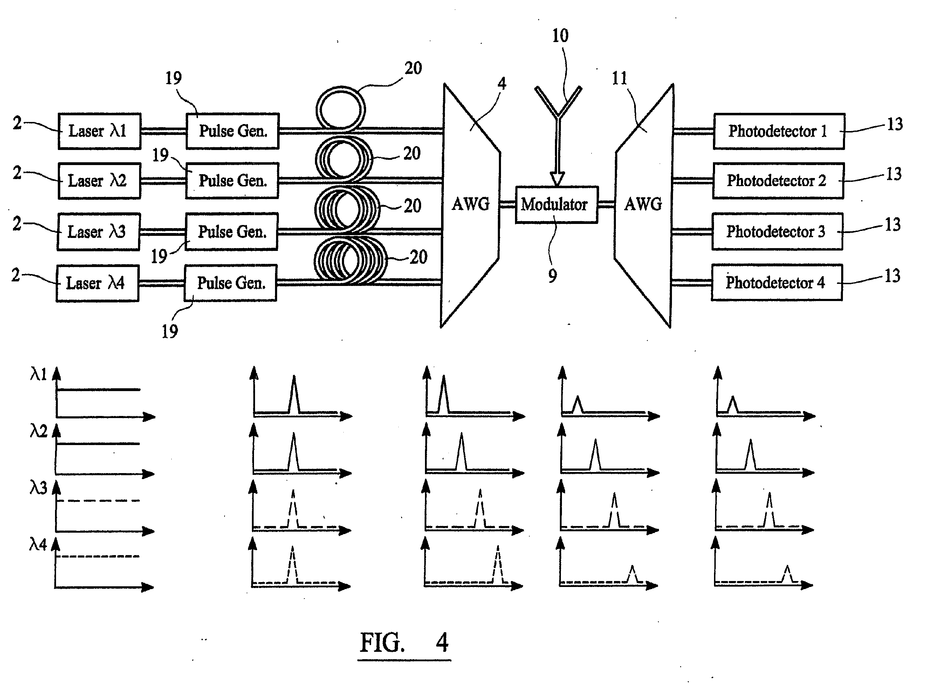

Shown in figure 4 is a fourth embodiment of a device according to the invention. This device is similar to the device of figure 3 except the single dispersive optical element 6 after the AWG combiner 4 is replaced by a plurality of delay elements 20 before the combiner 14. In this embodiment the delay element 20 is an optical fibre 20. Each optical fibre 20 is connected between further pulse generators 19 and the corresponding input port of the AWG optical combiner 4. In use each pulse generator19 produces an optical pulse train of the wavelength of its corresponding CW laser 2. Each optical pulse train then passes through the corresponding optical fibre 20 introducing delays between the optical pulse trains These optical pulse trains are then combined by the AWG optical combiner 4 before being passed to the optical modulator 9. Again, each pulse generator 19 can be clocked at a different clock frequency if required. Also, the delay experienced by each optical pulse train may be adjusted individually without affecting the other optical pulse trains by adjusting the length of the optical fibre 20 through which it passes.

The embodiments of figures 2 and 4 have a further advantage. Optical pulse trains of only one wavelength pass through each of the optical fibres 18, 20. One may therefore choose each fibre 18, 20 such that each fibre 18, 20 has ideal properties at the wavelength of the optical pulse train passing through it. Each fibre 18, 20 may be of a different composition if required.

In a further embodiment of the invention (not shown) at least one of the ADCs is connected to a plurality of photodetectors each connected to an output from the final optical splitter. This increases the rate at which the ADCs must digitise the received optical signals but reduces the number of ADCs required.

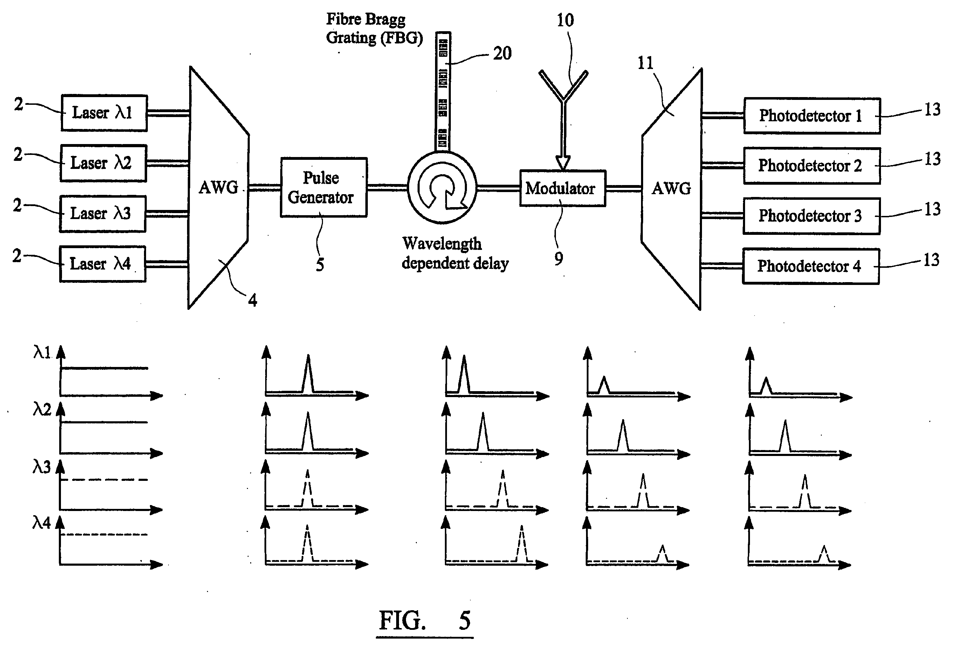

Shown in figure 5 is a fifth embodiment of a device according to the invention. This embodiment is similar to that of figure 1 except the dispersive optical element comprises a fibre Bragg grating 20. The operation of such a grating 20 is well known and will not be discussed further.

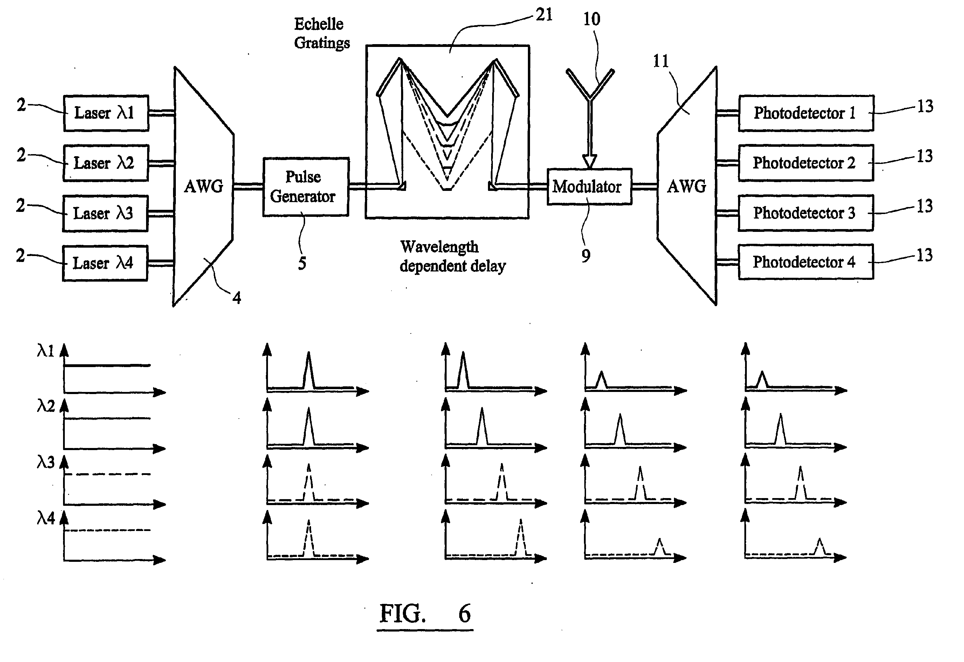

Shown in figure 6 is a sixth embodiment of a device according to the invention. Again, this device is similar to that of figure 1 except the dispersive optical element is a echelle grating 21.

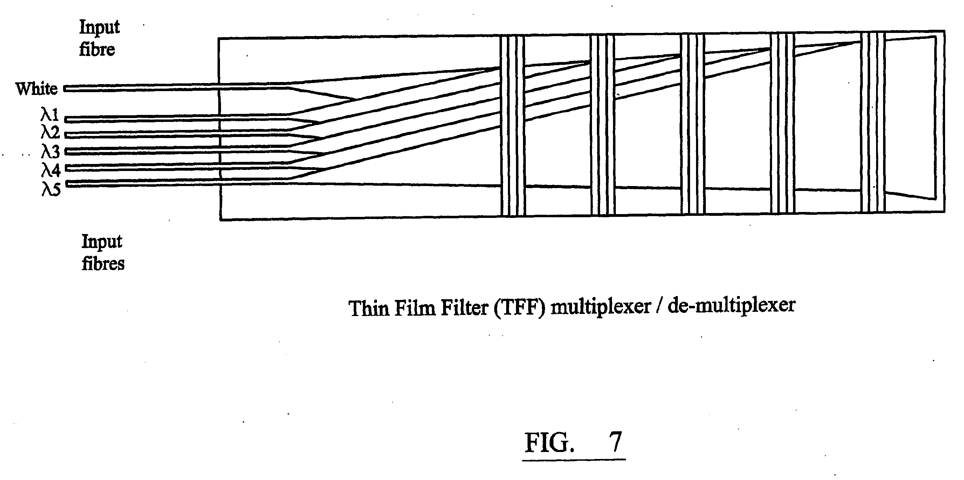

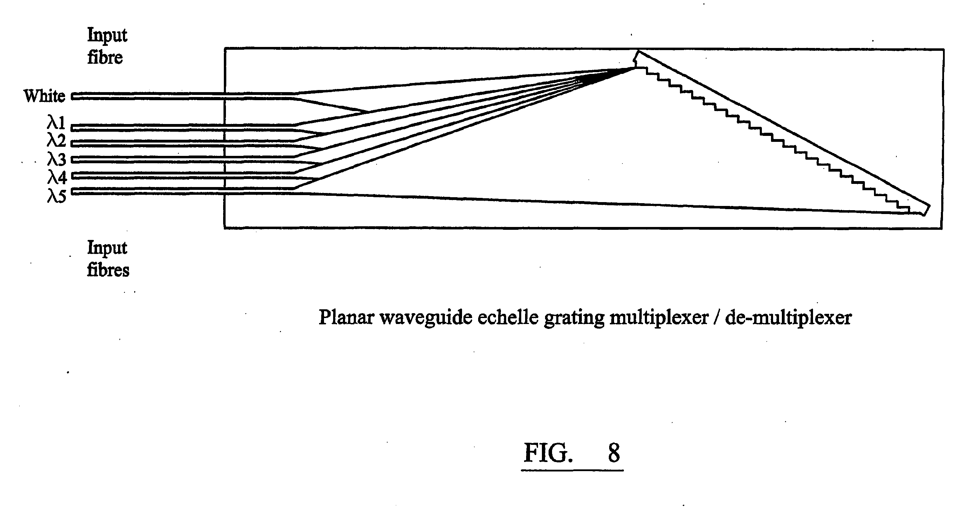

The devices of figures 1 to 6 all include Arrayed Waveguide Gratings as optical splitters and combiners. Other optical devices are possible. Shown in figures 7 and 8 are a thin film filter multiplexer/demultiplexer and a planar waveguide echelle grating multiplexer/demultiplexer. The operation of such devices is well known. A prism may also be used as a splitter or combiner.

## Claims

1. A device for digitising an electrical signal **characterized in that** it comprises
(A) at least two continuous wave lasers (2) each being adapted to produce light at a different wavelength;
(B) a dispersive optical chopper (3) adapted to chop the output of each of the lasers into pulse trains, introduce a predetermined delay between each of the pulse trains and to combine the pulse trains into a single optical path, the dispersive optical chopper comprising
(i) an optical combiner (4) having a plurality of input ports (7) each adapted to receive the output of a laser (2) and an output port (8), the optical combiner (4) being adapted to combine the optical signals received at the plurality of input ports at the output port (8)
(ii) an optical pulse generator (5) adapted to receive continuous optical signals at one or more wavelengths from the output of the optical combiner (4) and to convert these into one or more optical pulse trains at these wavelengths; and,
(iii) a dispersive optical element (6,14,20,21) connected between the optical pulse generator (5) and the port of an optical modulator (9) to introduce a wavelength dependent delay between optical pulse trains received from the optical pulse generator (5)
(C) the optical modulator (9) having an input port adapted to receive the output of the dispersive optical chopper (3), an output port and at least one optical path extending therebetween, the modulator (9) being adapted to receive a microwave signal and to modulate the amplitude of the optical signal in the optical path in response to the microwave signal;
(D) an optical splitter (11) for splitting the signal received from the output port of the modulator (9) into a plurality of wavelength dependent signal paths (12); and,
(E) a plurality of analogue to digital converters (13) each connected to at least one wavelength dependent signal path (12) for connecting the received optical signal to a digital signal.

2. A device (1) as claimed in claim 1, wherein the dispersive optical element (6,14,20,21) comprises an optical fibre (6) preferably a fibre optic cable.

3. A device (1) as claimed in claim 1, wherein the dispersive optical element (6,14,20,21) is a fibre Bragg grating.

4. A device (1) as claimed in claim 1, wherein the dispersive optical element is an echelle grating (21).

5. A device (1) as claimed in claim 1, wherein the dispersive optical element comprises
(i) a second optical splitter (15) adapted to split received optical pulse trains into a plurality of wavelength dependent paths (18);
(ii) a second optical combiner (16) adapted to receive optical signals at a plurality of input ports and combine them at an output port; and,
(iii) a plurality of delay elements (18), each delay element (18) being connected between an output of the second optical splitter (15) and a corresponding input of the second optical combiner (16).

6. A device as claimed in claim 5, wherein the delay element (18) comprises an optical fibre, preferably a fibre optic cable.

7. A device as claimed in any one of claims 1 to 6, wherein at least one optical splitter (15) is an arrayed waveguide grating.

8. A device as claimed in any one of claims 1 to 6 wherein at least one optical splitter (15) is a thin film splitter.

9. A device as claimed in any one of claims 1 to 6, wherein the at least one optical splitter (15) is a planer waveguide grating.

10. A device as claimed in any one of claims 1 to 9, wherein at least one optical combiner (4,16) is an arrayed waveguide grating.

11. A device as claimed in any one of claims 1 to 9, wherein the at least one optical combiner (4,16) is a thin film filter.

12. A device as claimed in any one of claims 1 to 9, wherein the at least one optical combiner (4,16) is a planar waveguide echelle grating.

13. A method of digitising an electrical signal **characterized in that** it comprises the steps of
(A) providing a plurality of continuous wave lasers (2) each providing a continuous optical wave at a different wavelength;
(B) combining the output of the plurality of lasers (2) into a single optical path:
(C) converting the continuous optical waves into a plurality of optical pulse trains at different wavelengths by means of an optical chopper;
(D) introducing a time delay between the pulse trains by passing the optical pulse trains through at least one dispersive optical element;
(E) passing each of the optical pulse trains through an optical modulator (9) where it is modulated by a received microwave signal;
(F) splitting the modulated optical pulse trains into a plurality of wavelength dependent paths;
(G) converting each of the modulated optical pulse trains into a digital signal.

14. A method as claimed in claim 13, wherein the combination is performed by an arrayed waveguide grating (4,16).

15. A method as claimed in claim 13, wherein the combination Is performed by a thin film filter.

16. A method as claimed in claim 13, wherein the combination is performed by an echelle grating.

17. A method as claimed in claim 13, wherein the dispersive optical element is an optical fibre, preferably a fibre optic cable.

18. A method as claimed in claim 13, wherein the dispersive optical element is (6,18) is an echelle grating or fibre Bragg grating.

## Patentansprüche

1. Vorrichtung zum Digitalisieren eines elektrischen Signals, **dadurch gekennzeichnet, dass** die Vorrichtung umfasst:
(A) wenigstes zwei CW-Laser (2), wobei jeder dazu ausgestaltet ist, Licht bei einer anderen Wellenlänge zu erzeugen;
(B) einen dispergierenden optischen Chopper (3), der dazu ausgestaltet ist, die Ausgabe von jedem der Laser in Pulsabfolgen zu choppen, eine vorbestimmte Verzögerung zwischen jede der Pulsabfolgen einzubringen und die Pulsabfolgen in einen einzigen optischen Weg zu kombinieren, wobei der dispergierende optische Chopper umfasst:
(i) eine optische Kombiniereinrichtung (4) mit einer Vielzahl von Eingabeports (7), von denen jeder dazu ausgestaltet ist, die Ausgabe eines Lasers (2) zu empfangen, sowie einem Ausgabeport (8), wobei die optische Kombiniereinrichtung (4) dazu ausgestaltet ist, die optischen Signale am Ausgabeport zu kombinieren, die bei der Vielzahl von Eingabeports empfangen werden;
(ii) einen Generator (5) optischer Pulse, der dazu ausgestaltet ist, bei einer oder mehreren Wellenlängen von der Ausgabe der optischen Kombiniereinrichtung (4) kontinuierliche optische Signale zu empfangen und diese in eine oder mehrere optische Pulsabfolgen bei diesen Wellenlängen zu Konvertieren; und
(iii) ein dispergierendes optisches Element (6, 14, 20, 21), das zwischen dem Generator (5) optischer Pulse und dem Port eines optischen Modulators (9) verbunden ist, um eine wellenlängenabhängige Verzögerung zwischen optischen Pulsabfolgen einzubringen, die von dem Generator (5) optischer Pulse empfangen werden;
(C) wobei der optische Modulator (9) einen Eiugabesport aufweist, der dazu ausgestaltet ist, die Ausgabe des dispergierenden optischen Choppers (3) zu empfangen, einen Ausgabeport sowie wenigstens einen optischen Weg, der sich dazwischen erstreckt, wobei der Modulator (9) dazu ausgestaltet ist, ein Mikrowellensignal zu empfangen und die Amplitude des optischen Signals in dem optischen Weg in Reaktion auf das Mikrowellensignal zu modulieren;
(D) einen optischen Splitter (11), um das vom Ausgabeport des Modulators (9) empfangene Signal in eine Vielzahl von wellenlängenabhängigen Signalwege (12) aufzusplitten; und
(E) eine Vielzahl von Analog-/Digital-Konvertern (13), von denen jeder mit wenigstens einem wellenlängenabhängigen Signalweg (12) verbunden ist, um das empfangene optische Signal mit einem digitalen Signal zu verknüpfen.

2. Vorrichtung (1) nach Anspruch 1, wobei das dispergierende optische Element (6, 14, 20, 21) eine optische Faser (6), vorzugsweise ein Faserkabel, umfasst.

3. Vorrichtung (1) nach Anspruch 1, wobei das dispergierende optische Element (6, 14, 20, 21) ein Bragg-Fasergitter ist.

4. Vorrichtung (1) nach Anspruch 1, wobei das dispergierende optische Element ein Echelle-Gitter (21) ist.

5. Vorrichtung (1) nach Anspruch 1, wobei das dispergierende optische Element umfasst:
(i) einen zweiten optischen Splitter (15), der dazu ausgestaltet ist, empfangene optische Pulsabfolgen in eine Vielzahl von wellenlängenabhängigen Wegen (18) aufzusplitten;
(ii) eine zweite optische Kombiniereinrichtung (16), die dazu ausgestaltet ist, optische Signale bei einer Vielzahl von Eingabeports zu empfangen und diese an einem Ausgabeport zu kombinieren; und
(iii) eine Vielzahl von Verzögerungselementen (18), wobei jedes Verzögerungselement (18) zwischen einer Ausgabe des zweiten optischen Splitters (15) und einer entsprechenden Eingabe der zweiten optischen Kombiniereinrichtung (16) verbunden ist.

6. Vorrichtung nach Anspruch 5, wobei das Verzögerungselement (18) eine optische Faser umfasst, vorzugsweise ein optisches Faserkabel.

7. Vorrichtung nach einem der Ansprüche 1 bis 6, wobei wenigstens ein optischer Splitter (15) ein gerastertes Wellenleitergitter ist.

8. Vorrichtung nach einem der Ansprüche 1 bis 6, wobei wenigstens ein optischer Splitter (15) ein Dünnfilmsplitter ist.

9. Vorrichtung nach einem der Ansprüche 1 bis 6, wobei der wenigstens eine optische Splitter (15) ein ebenes Wellenleitergitter ist.

10. Vorrichtung nach einem der Ansprüche 1 bis 9, wobei wenigstens eine optische Kombiniereinrichtung (4, 16) ein gerastertes Wellenleitergitter ist.

11. Vorrichtung nach einem der Ansprüche 1 bis 9, wobei die wenigstens eine optische Kombiniereinrichtung (4, 16) ein Dünnfilmfilter ist.

12. Vorrichtung nach einem der Ansprüche 1 bis 9, wobei die wenigstens eine optische Kombiniervorrichtung (4, 16) ein planares WellenleiterEchelle-Gitter ist.

13. Verfahren zum Digitalisieren eines elektrischen Signals, **dadurch gekennzeichnet, dass** das Verfahren die Schritte umfasst:
(A) das Bereitstellen einer Vielzahl von CW-Lasern (2), wobei jeder Laser eine kontinuierliche optische Welle bei einer anderen Wellenlänge liefert;
(B) das Kombinieren der Ausgabe der Vielzahl von Lasern (2) in einen einzelnen optischen Weg;
(C) das Konvertieren der kontinuierlichen optischen Wellen in eine Vielzahl von optischen Pulsabfolgen bei unterschiedlichen Wellenlängen mittels eines optischen Choppers;
(D) das Einbringen einer Zeitverzögerung zwischen den Pulsabfolgen, indem die optischen Pulsabfolgcn durch wenigstens ein dispergierendes optisches Element geführt werden;
(E) das Führen von jeder der optischen Pulsabfolgen durch einen optischen Modulator (9), wo es durch ein empfangenes Mikrowellensignal moduliert wird;
(F) das Aufsplitten der modulierten optischen Pulsabfolgen in eine Vielzahl von wellenlängenabhängigen Wegen;
(G) das Konvertieren von jeder der modulierten optischen Pulsabfolgen in ein digitales Signal.

14. Verfahren nach Anspruch 13, wobei das Kombinieren von einem gerasterten Wellenleiter-Gitter (4, 16) durchgeführt wird.

15. Verfahren nach Anspruch 13, wobei das Kombinieren von einem Dünnfilmfilter durchgeführt wird.

16. Verfahren nach Anspruch 13, wobei das Kombinieren von einem Echelle-Gitter durchgeführt wird.

17. Verfahren nach Anspruch 13, wobei das dispergierende optische Element eine optische Faser, vorzugsweise ein optisches Faserkabel, ist.

18. Verfahren nach Anspruch 13, wobei das dispergierende optische Element (6, 18) ein Echelle-Gitter oder ein Bragg-Faser-Gitter ist.

## Revendications

1. Dispositif de numérisation d'un signal électrique **caractérisé en ce qu'**il comprend :
(A) au moins deux lasers à onde continue (2), chacun étant adapté à produire de la lumière à une longueur d'onde différente l'une de l'autre ;
(B) un hacheur optique à dispersion (3) adapté à hacher la sortie de chacun des lasers en trains d'impulsions, à introduire un délai prédéterminé entre chacun des trains d'impulsion et à combiner les trains d'impulsion en une trajectoire optique unique, le hacheur optique à dispersion comprenant :
(i) un collecteur optique (4) présentant une pluralité de ports d'entrée (7), chacun étant adapté à recevoir la sortie d'un laser (2), et un port de sortie (8), le collecteur optique (4) étant adapté à combiner les signaux optiques reçus en provenance de la pluralité de ports d'entrée au niveau du port de sortie (8)
(ii) un générateur d'impulsion optique (5) adapté à recevoir des signaux optiques continus à une ou plusieurs longueurs d'onde en provenance de la sortie du collecteur optique (4) et de les convertir en un ou plusieurs trains d'impulsion optiques à ces longueurs d'onde ; et,
(iii) un élément optique à dispersion (6,14,20,21) connecté entre le générateur d'impulsion optique (5) et le port d'un modulateur optique (9) afin d'introduire un laps de temps dépendant de la longueur d'onde entre les trains d'impulsion optique reçus en provenance du générateur d'impulsion optique (5) ;
(C) le modulateur optique (9) présentant un port d'entrée adapté à recevoir la sortie du hacheur optique à dispersion (3), un port de sortie et au moins une trajectoire optique qui s'étend depuis l'un vers l'autre, le modulateur (9) étant adapté à recevoir un signal à microonde et à moduler l'amplitude du signal optique dans la trajectoire optique en réponse aus signal à micro-onde ;
(D) un séparateur optique (11) pour séparer le signal reçu en provenance du port de sortie du modulateur (9) en une pluralité (12) de trajectoires à signaux dépendantes de la longueur d'onde ; and,
(E) une pluralité de convertisseurs analogique-numérique (13) chacun étant connecté à au moins une trajectoire (12) à signaux dépendante de la longueur d'onde afin de connecter le signal optique reçu à un signal numérique.

2. Dispositif (1) selon la revendication 1, dans lequel l'élément à dispersion optique (6,14,20,21) comprend une fibre optique (6), de préférence un câble optique.

3. Dispositif (1) selon la revendication 1, dans lequel l'élément à dispersion optique (6,14,20,21) est une fibre optique à réseau de Bragg.

4. Dispositif (1) selon la revendication 1, dans lequel l'élément à dispersion optique est un réseau de diffraction en échelle (21).

5. Dispositif (1) selon la revendication 1, dans lequel l'élément à dispersion optique comprend :
(i) un deuxième séparateur optique (15) adapté à séparer des trains d'impulsion reçus en une pluralité de trajectoires dépendantes de la longueur d'onde (18) ;
(ii) un deuxième collecteur optique (16) adapté à recevoir des signaux optiques à une pluralité de ports d'entrée et les combiner au niveau d'un port de sortie ; et,
(iii) une pluralité d'éléments retardateurs (18), chaque élément retardateur (18) étant connecté entre une sortie du deuxième séparateur optique (15) et une entrée correspondante du deuxième collecteur optique (16).

6. Dispositif selon la revendication 5, dans lequel l'élément retardateur (18) comprend une fibre optique, de préférence un câble optique.

7. Dispositif selon l'une quelconque des revendications 1 à 6, dans lequel au moins un séparateur optique (15) est un réseau de diffraction à guide d'ondes matriciel.

8. Dispositif selon l'une quelconque des revendications 1 à 6, dans lequel au moins un séparateur optique (15) est un séparateur à couche mince.

9. Dispositif selon l'une quelconque des revendications 1 à 6, dans lequel le au moins un séparateur optique (15) est un réseau de diffraction à guide d'ondes plan.

10. Dispositif selon l'une quelconque des revendications 1 à 9, dans lequel au moins un collecteur optique (4,16) est un réseau de diffraction en guide d'ondes matriciel.

11. Dispositif selon l'une quelconque des revendications 1 à 9, dans lequel le au moins un collecteur optique (4,16) est un filtre à couche mince.

12. Dispositif selon l'une quelconque des revendications 1 à 9, dans lequel le au moins un collecteur optique (4,16) est un réseau de diffraction en échelle à guide d'ondes plan.

13. Méthode de numérisation d'un signal électrique, **caractérisé en ce qu'**il comprend les étapes comprenant :
(A) la fourniture d'une pluralité de lasers à onde continue (2), chacun fournissant une onde optique continue à des longueurs d'onde différentes l'une de l'autre ;
(B) combiner les sorties de la pluralité de lasers (2) en une trajectoire optique unique ;
(C) convertir les ondes optiques continues en une pluralité de trains d'impulsion optique présentant des longueurs d'ondes différentes par le biais d'un hacheur optique ;
(D) introduire un laps de temps entre les trains d'impulsion en faisant passer les trains d'impulsion optique à travers au moins un élément à dispersion optique ;
(E) faire passer chacun des trains d'impulsion optique à travers un modulateur optique (9), dans lequel il est modulé par un signal à micro-onde reçu ;
(F) séparer les trains d'impulsion optique modulés en une pluralité de trajectoires dépendantes de la longueur d'onde ;
(G) convertir chacun des trains d'impulsion optique modulés en un signal numérique.

14. Méthode selon la revendication 13, dans laquelle la combinaison est effectuée par un réseau de diffraction à guide d'ondes matriciel (4,16).

15. Méthode selon la revendication 13, dans laquelle la combinaison est effectuée par un filtre à couche mince.

16. Méthode selon la revendication 13, dans laquelle la combinaison est effectuée par un réseau de diffraction en échelle.

17. Méthode selon la revendication 13, dans laquelle l'élément optique à dispersion est une fibre optique, de préférence un câble optique.

18. Méthode selon la revendication 13, dans laquelle l'élément optique à dispersion (6,18) est un réseau de diffraction en échelle ou une fibre optique à réseau de Bragg.
